Europäisches Patentamt

European Patent Office

Office européen des brevets

(11) Numéro de publication: **0 296 528**
**A1**

## (12) DEMANDE DE BREVET EUROPEEN

(21) Numéro de dépôt: 88109837.0

(22) Date de dépôt: 21.06.88

(51) Int. Cl.⁴: **H03K 3/57 , H03K 17/80**

(30) Priorité: 26.06.87 FR 8709039

(43) Date de publication de la demande:
28.12.88 Bulletin 88/52

(84) Etats contractants désignés:
AT BE CH DE ES FR GB GR IT LI LU NL SE

(71) Demandeur: COMPAGNIE GENERALE
D'ELECTRICITE Société anonyme dite:
54, rue La Boétie
F-75382 Paris Cédex 08(FR)

(72) Inventeur: Pinson, Pierre
Rue de la Fontaine Vaugrigneuse
F-91640 Briis Sous Forges(FR)

(74) Mandataire: Weinmiller, Jürgen et al
Lennéstrasse 9 Postfach 24
D-8133 Feldafing(DE)

(54) Générateur d'impulsions électriques de puissance avec compression temporelle étagée notamment pour laser à décharge.

(57) Un circuit de départ comporte une source continue (S4) un condensateur de stockage (C12), et un thyristor de déclenchement (T4). Il fournit une impulsion de départ de tension plus faible et de durée plus grande que l'impulsion que doit être appliquée à une charge (Z4). Cette dernière impulsion est obtenue à l'aide de deux étages de compression temporelle et d'élévation de tension en série. Chaque étage, par exemple le premier, comporte un condensateur de stockage (C13), une inductance saturable de compression temporelle (L10) et un transformateur élévateur (TR5).

L'invention s'applique notamment à l'alimentation des lasers.

FIG.5

EP 0 296 528 A1

# Générateur d'impulsions électriques de puissance avec compression temporelle étagée, notamment pour laser à décharge.

La présente invention concerne la production d'impulsions de puissance brèves notamment dans des systèmes pouvant fonctionner à cadence élevée.

Il s'agit de fournir à une charge, qui peut par exemple être un laser, des impulsions de courant de plusieurs centaines d'ampères sous plusieurs milliers de volts pendant des durées de quelques dizaines ou centaines de nanosecondes.

L'etat de la technique est le suivant :

On connaît tout d'abord des dispositifs d'aide à la commutation par circuits magnétiques saturables :

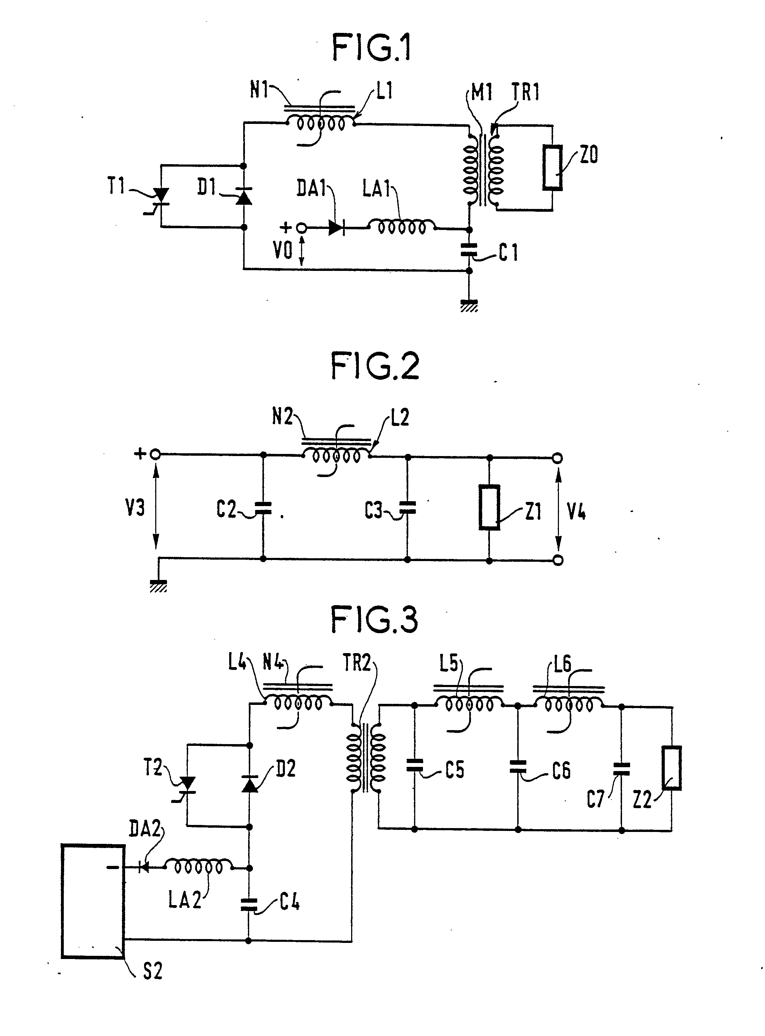

Le schéma d'un tel dispositif est représenté sur la figure 1.

Dans ce schéma classique, une fois le régime périodique établi, un condensateur de stockage C1 est rechargé, à une cadence de fonctionnement convenable, à deux fois la valeur d'une tension continue d'alimentation Vo à travers une diode et une inductance d'alimentation DA1 et LA1. Une impulsion de commande déclenche alors en conduction le thyristor T1. Le courant est au début faible car une inductance L1 à noyau magnétique saturable N1 présente une valeur élevée. Au bout d'un certain temps appelé temps de saturation ou temps de blocage, cette inductance se sature et la valeur de son impédance chute rapidement permettant la circulation d'un courant élevé. Pendant le temps de blocage du courant principal par l'inductance saturable L1 le thyristor a eu le temps de devenir conducteur sur une grande surface. Il présente donc des pertes plus faibles au moment du passage du courant principal. La mise en oeuvre d'un tel dispositif permet d'utiliser les thyristors pour engendrer des impulsions plus courtes que celles correspondant aux spécifications habituelles fixées par les fournisseurs.

Les impulsions sont appliquées à une charge Z0 à travers un transformateur TR1. Une diode de récupération D1 est montée tête bêche avec le thyristor T1 pour le protéger des inversions de tensions.

Il n'y a pas de restriction pour un circuit fonctionnant à basse cadence ou en coup par coup avec, dans ce dernier cas, un système de charge différent de la capacité C1.

On connaît ensuite des dispositifs de compression d'impulsions par circuit magnétique qui ont d'abord été utilisés dans le domaine des radars -voir le document (1) dont les références bibliographiques sont indiquées en fin de description-. Un tel dispositif est représenté sur la figure 2.

Une tension V3 est fournie par une source extérieure qui présente une résistance interne et qui charge un condensateur de stockage C2 en un temps juste inférieur au temps de saturation d'une inductance L2 à noyau magnétique saturable N2. Cette inductance se sature alors rapidement et la charge du condensateur C2 s'écoule dans un condensateur C3 et une impédance de charge Z1 en un temps plus court que le temps de charge de C2.

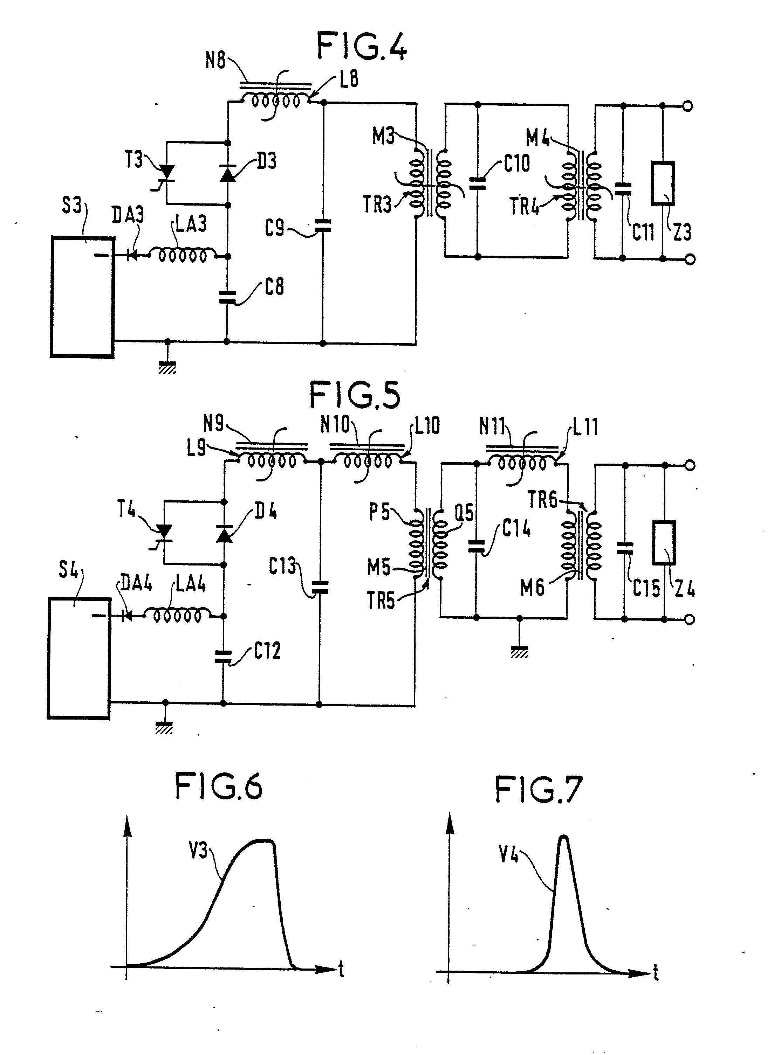

Les variations des tensions V3 aux bornes du condensateur C2 et V4 aux bornes du condensateur C3 sont représentées sur les figures 6 et 7, respectivement.

Sur ce principe on peut constituer un système de compression d'impulsion à plusieurs étages successifs. Ceci permet de reporter la fonction de commutateur initial sur un composant capable de commuter toute l'énergie nécessaire mais en un temps beaucoup plus long que la durée de décharge finale exigée par l'application envisagée -voir le document (2)-.

Si par exemple on utilise des thyristors et que l'application nécessite une tension de plusieurs kilovolts on utilisera un circuit similaire à celui de la figure 3.

L'énergie nécessaire à chaque impulsion est stockée dans un condensateur de stockage de départ C4 à partir d'une source de tension continue S2 travers une diode et une inductance d'alimentation DA2 et LA2. Un thyristor T2 joue le rôle d'interrupteur primaire. Il est monté tête bêche avec une diode de récupération D2. Une première inductance saturable L4 constitue une aide à la commutation. Un transformateur Tr2 permet d'élever la tension en la multipliant par un nombre qui constitue son rapport de transformation. Un ensemble d'éléments tels que S2, DA2, LA2, C4, T2, D2 et L4 avec un noyau N4 sera appelé ci-après "circuit de départ". Le transformateur TR2 transfère l'énergie de ce circuit à un condensateur de stockage C5, ceci dans le même temps et sous une tension accrue. Une deuxième inductance saturable L5 est réalisée pour se saturer lorsque cette tension accrue atteint son maximum. Elle transfère l'énergie de C5 à un condensateur de stockage C6 en un temps plus court que le précédent, c'est-à-dire égal au temps précédent divisé par un nombre qui constitue le rapport de compression de cette inductance. Elle constitue avec le condensateur C5 un premier étage de compression.

Le document (9) décrit un système utilisant un thyratron et un seul étage de compression. Dans les documents (10) et (11) sont décrites des alimentations pulsées à thyristor et transformateur d'impulsions avec plusieurs étages de compression magnétique.

Le temps de blocage d'un inductance saturable soumise à une tension moyenne V est proportionnel au nombre de tour de fil conducteur N et à la section S de matériau magnétique.

Dans un schéma comme celui de la figure 3 le premier étage de compression travaille avec un temps long et un tension maximale d'impulsion élevée car cette tension est à peu près celle de l'impulsion qui doit être appliquée à la charge Z2. Compte tenu du fait que la saturation de l'inductance doit intervenir à un moment où la tension à ses bornes atteint une valeur proche de cette tension maximale il faut que le matériau ferromagnétique de la bobine constituant l'inductance L5 présente une section S importante ou que cette bobine comporte un nombre de tours N élevé. Pour que le transfert d'énergie de C5 en C6 soit rapide on est obligé de limiter le nombre de tours N à une valeur aussi faible que possible ; il faut donc choisir S grand.

Les inconvénients principaux d'un tel choix résultent de la nécessité d'une grande quantité de matériau ferromagnétique. Ce sont le poids et l'encombrement de ce matériau, et les pertes d'énergie, qui sont importantes puisqu'elles sont proportionnelles au volume de ce matériau.

Une solution à ce problème a été proposée par exemple dans le document (4) et est schématisée sur la figure 4. Le générateur selon ce document pourrait comporter un circuit de départ S3, DA3, LA3, C8, T3, D3, L8 du type précédemment décrit, un premier étage de compression C9, TR3, et un deuxième étage de compression C10, TR4, un condensateur C11 étant connecté en parallèle avec la charge Z3.

Les transformateurs Tr3 et Tr4 comporteraient des noyaux saturables M3 et M4 qui leur feraient jouer le rôle d'inductances saturables de compression temporelle. Chacun de ces transformateurs présenterait un rapport de transformation égal à son rapport de compression ce qui permettrait d'un étage à l'autre de réaliser la compression à courant constant et à tension croissante, c'est-à-dire de diminuer la tension et le volume de matériau ferromagnétique, par rapport au dispositif de la figure 3 dans lequel la compression est effectuée à tension constante et à courant croissant. Mais on se heurte à l'heure actuelle à une impossibilité pratique de réaliser un tel type de transformateur qui présente un rendement suffisant pour aboutir à la diminution souhaitée des pertes. Cette solution à transformateur saturable a donc été souvent considérée comme dépourvue de tout intérêt.

La présente invention a pour but de produire simplement des impulsions de puissance brèves avec des pertes diminuées.

Elle a également pour buts de diminuer le poids, le prix et/ou l'encombrement d'un matériau ferromagnétique nécessaire à la production de telles impulsions.

Elle a encore pour but de permettre la production de telles impulsions à une cadence accrue.

Et elle a pour objet un générateur d'impulsions électriques de puissance avec compression temporelle étagée, notamment pour laser à décharge, ce générateur étant destiné à appliquer à une charge une impulsion électrique finale énergétique et brève, ce générateur comportant,

- un circuit de départ pour engendrer une impulsion électrique de départ présentant une durée plus grande, une tension plus basse, et une énergie voisine et plus grande que ladite impulsion finale,

- et une succession d'étages de compression avec élévation de tension, chacun de ces étages recevant une impulsion d'entrée et fournissant une impulsion de sortie de durée diminuée et de tension augmentée, l'impulsion de sortie d'un étage constituent l'impulsion d'entrée de l'étage suivant, cette succession comportant au moins un premier étage dont l'impulsion d'entrée est constituée par ladite impulsion de départ et un dernier étage dont l'impulsion de sortie constitue ladite impulsion finale, chacun de ces étages comportant,

- un condensateur de stockage chargé progressivement par ladite impulsion d'entrée,

- et un transformateur élévateur de tension présentant un enroulement primaire connecté aux bornes de ce condensateur de stockage au sein d'un circuit d'étage pour recevoir le courant de la décharge de ce condensateur de stockage, ce transformateur présentant un enroulement secondaire couplé magnétiquement à ce circuit d'étage par l'intermédiaire de cet enroulement primaire pour fournir ladite impulsion de sortie,

- un enroulement coopérant avec un noyau d'enroulement saturable constitué d'un volume limité d'un matériau ferromagnétique pour faire intervenir une inductance de compression temporelle dans ce circuit d'étage, cette inductance étant saturable avec ce noyau et présentant d'abord une valeur initiale importante qui s'oppose à une croissance rapide du courant de ladite décharge du condensateur de stockage lorsque l'intensité de ce courant est inférieure à un seuil de saturation au début de cette décharge avant la charge complète de ce condensateur, cette inductance présentant ensuite une valeur de saturation minime qui permet une croissance rapide de ce courant et qui résulte de la saturation magnétique de ce matériau lorsque cette intensité a dépassé ledit seuil de saturation, cette croissance rapide permettant audit transformateur de former ladite impulsion de sortie avec ladite durée diminuée, ce noyau étant en même temps le siège d'une perte d'énergie qui est d'autant plus grande que ledit volume de matériau ferromagnétique est grand et qui diminue l'énergie disponible pour former cette impulsion de sortie,

- ce générateur étant caractérisé par le fait que ledit noyau saturable coopère pour former ladite inductance de compression avec un enroulement de compression qui est magnétiquement découplé dudit transformateur et qui est connecté en série avec ledit condensateur de stockage et ledit enroulement primaire de ce transformateur dans ledit cicuit d'étage.

Selon l'invention on peut adopter de plus, selon les circonstances, les dispositions complémentaires suivantes :

- chaque dit étage de compression est muni de deux noyaux de matériau ferromagnétique, l'un étant ledit noyau saturable qui coopère avec ledit enroulement de compression, l'autre étant un noyau de transformateur non saturable couplé aux dits enroulement primaire et secondaire et présentant un volume suffisant pour éviter une saturation lorsque le courant de la dite décharge du condensateur de stockage atteint son intensité maximale.

- Chaque dit étage de compression présente un rapport de transformation compris entre le double et la moitié de son rapport de compression, ce rapport de compression étant le rapport de la durée de ladite impulsion d'entrée à celle de ladite impulsion de sortie, ce rapport de transformation étant le rapport du nombre de spires dudit enroulement secondaire à celui dudit enroulement primaire,

- Ledit dernier étage de compression comporte un condensateur en parallèle avec ladite charge.

La présente invention met en oeuvre deux couplages magnétique et, de préférence, deux noyaux ferromagnétiques correspondants, ceci dans chaque étage de compression. L'expérience montre cependant qu'elle permet de réaliser convenablement à chaque étage les fonctions de compression et d'élévation de tension tout en diminuant le total des volumes de matériau magnétique qui sont nécessaires aussi bien dans les transformateurs que dans les inductances saturables de compression temporelle. C'est cette diminution de ces volumes qui permet d'obtenir une diminution des pertes et d'atteindre les autres buts de la présente invention.

A l'aide de la figure schématique 5 ci-jointe on va décrire plus particulièrement ci-après, à titre d'exemple non limitatif, un mode de mise en oeuvre de l'invention. Ce mode de mise en oeuvre présente les dispositions complémentaires précédemment mentionnées. Il doit être compris que les éléments décrits et représentés peuvent, sans sortir du cadre de l'invention, être remplacés par d'autres éléments assurant les mêmes fonctions techniques. Lorsqu'un même élément est représenté sur plusieurs figures il y est désigné par le même signe de référence. On rappelle que :

la figure 1 représente un schéma d'un premier générateur connu ;

la figure 2 représente un schéma d'un deuxième générateur connu ;

la figure 3 représente un schéma d'un troisième générateur connu ;

la figure 4 représente un schéma d'un quatrième générateur antérieurement proposé ;

ces quatre figures ayant déjà été décrites.

La figure 5 représente un schéma d'un générateur selon l'invention.

Ce générateur comporte un circuit de départ du type précédemment décrit avec une source continue S4, une diode et une inductance d'alimentation DA4 et LA4, un condensateur de stockage C12, un thyristor de déclenchement T4, une diode de récupération D4, et une inductance saturable d'aide à la commutation L9 munie d'un noyau N9.

Un premier étage de compression comporte un condensateur de stockage C13 chargé progressivement par ladite impulsion d'entrée, et un transformateur élévateur de tension TR5 présentant un enroulement primaire P5 connecté aux bornes de ce condensateur de stockage au sein d'un circuit d'étage pour recevoir le courant de la décharge de ce condensateur de stockage. Ce transformateur présente un enroulement secondaire Q5 couplé magnétiquement à ce circuit d'étage par l'intermédiaire de cet enroulement primaire. Un enroulement de compression, à savoir celui de l'inductance saturable de compression de cet étage L10, est muni d'un noyau N10 constitué d'un volume limité d'un matériau ferromagnétique pour former une inductance de compression temporelle dans ce circuit d'étage. Cette inductance est saturable avec ce noyau, c'est-à-dire qu'elle présente une valeur initiale importante qui s'oppose à une croissance rapide du courant de ladite décharge du condensateur de stockage C13, lorsque l'intensité de ce courant est inférieure à un seuil de saturation au début de cette décharge avant la charge complète de ce condensateur. Elle présente ensuite une valeur de saturation minime qui permet une croissance rapide de ce courant et qui résulte de la saturation magnétique de ce noyau lorsque cette intensité a dépassé ledit seuil de saturation. C'est cette croissance rapide qui permet au transformateur TR5 de former impulsion de sortie de cet étage avec ladite durée diminuée.

Il n'y a aucun couplage magnétique entre cet enroulement de compression et les enroulements primaire P5 ou secondaire Q5 du transformateur TR5.

Un deuxième étage de compression comporte des éléments homologues des précédents, avec des valeurs évidemment différentes. Ces éléments homologues sont désignés par les références suivants :

condensateur C14, transformateur TR6 avec noyau M6, inductance de compression L11 avec noyau saturable N11.

Un condensateur C15 est connecté en parallèle sur la charge Z4.

L'inductance saturable L10 est réalisée pour que le courant qui la traverse soit n1 fois plus court que le courant qui a circulé dans le thyristor T4. Le transformateur Tr5 est réalisé pour élever la tension dans un rapport n2.

Si l'on choisi n1 = n2 l'inductance saturable L11 devra avoir le même produit NS que l'inductance L10.

Un tel schéma mettant en oeuvre une compression magnétique répartie en fonction de l'élévation de tension permet de minimiser le volume nécessaire de matériau magnétique et d'améliorer le rendement d'un tel générateur d'alimentation pulsée, notamment pour un laser de puissance à décharge.

On peut consulter les documents suivants :

(1) S.W. MELEVILLE "The use of saturable reactors as discharge devices for pulse generators" Proc.Institution of Electrical Engineers (IEE, London, England, 1951) Vol (3), p 185-207.

(2) D.L. BIRX, E.J. LAUR, L.L. REGINATO, J. SCHMIDT, M. SMITH Basic principles governing the design of magnetic switches LLNL UCID18831 nov 1980.

(3) W.C. NUNNALLY Magnetic switches and circuits LANL LA 8862-MS sept 81.

(4) W.C. NUNNALLY Stripline magnetic modulators for lasers and accelerators 3° IEEE Int. Pulsed Power Conf. 1981.

(5) D.L. BIRX, E.J. LAUER, L.L. REGINATO, D. ROGERS, M.W. SMITH, T. ZIMMERMAN 3° IEEE Int. Pulsed Power Conf. 1981.

(6) J.P. VANDEVENDER, R.A. REBER High voltage magnetically switched pulsed power systems 3° IEEE Int. Pulsed Power Conf. 1981.

(7) S.E. BALL, T.R. BURKES Saturable inductors as high power switches 3° IEEE Int. Pulsed Power Conf. 1981.

(8) C.H. SMITH, M. ROSEN Amorphous metal reactor cores for switching applications PCI'81 Proceedings.

(9) I. SMILANSKI, S.R. BYRON, T.R. BURDES Electrical excitation of an XeCl laser using magnetic pulse compression Appl. Phys. Lett. 40(7) 1981.

(10) T. SHIMADA, M. OBARA, A. NOGUCHI An all solid state magnetic switching exciter for pumping excimer lasers Rev.Sci Instrum. 56(11) 1985.

(11) H.J. BAKER, P.A. ELLSMORE, E.C. SILLE Efficient solid state magnetic pulser for gas laser excitation using ferrite materials WK27 CLEO'86 June 1986.

## Revendications

1/ Générateur d'impulsions électriques de puissance avec compression temporelle étagée, comportant,

- un circuit de départ (S4, DA4, LA4, C12, T4, D4, L9) pour engendrer une impulsion électrique de départ,

- et une succession d'étages de compression, chacun de ces étage recevant une impulsion d'entrée et fournissant une impulsion de sortie de durée diminuée qui constitue l'impulsion d'entrée de l'étage suivant éventuel, l'impulsion d'entrée d'un premier étage (C13, L10, TR5) étant constituée par ladite impulsion de départ, chacun de ces étages de compression comportant pour cela,

- un condensateur de stockage (C13) chargé progressivement par ladite impulsion d'entrée,

- et une inductance de compression connectée en série avec ce condensateur de stockage dans un circuit d'étage et formée par un enroulement de compression (L10) entourant un noyau saturable (N10) constitué d'un volume limité d'un matériau ferromagnétique, de manière que, lors de la décharge de ce condensateur, cette inductance présente d'abord une valeur initiale importante empêchant une croissance rapide du courant de cette décharge et ensuite une valeur de saturation minime permettant une croissance rapide de ce courant,

- ce générateur comportant en outre des transformateurs élévateurs de tension magnétiquement découplés desdites inductances de compression et élevant la tension de certaines desdites impulsions de manière que ce générateur fournisse une impulsion finale présentant à la fois une durée plus petite et une tension plus grande que ladite impulsion de départ,

- ce générateur étant caractérisé par le fait que chacun des dits étages de compression de la dite succession comporte en outre un dit transformateur élévateur de tension (TR5) dont un enroulement primaire (P5) est connecté en série avec ledit condensateur de stockage (C13) et ladite inductance de compression (L10, N10) et dont un enroulement secondaire (Q5) fournit la dite impulsion de sortie de cet étage, de manière que l'élévation de la tension desdites impulsions soit étagée et accompagne la diminution étagée de leurs durées.

2/ Générateur selon la revendication 1, caractérisé par le fait que chaque dit étage de compression (C13, L10, TR5) présente un rapport de transformation compris entre la moitié et le double de son rapport de compression, ce rapport de compression étant le rapport de la durée de ladite impulsion d'entrée à celle de ladite impulsion de sortie, ce rapport de transformation étant le rapport du nombre de spires dudit enroulement secondaire (Q5) à celui dudit enroulement primaire (P5).

3/ Générateur selon la revendication 2, caractérisé par le fait que ledit rapport de transformation est compris entre 80 % et 125 % dudit rapport de compression.

4/ Générateur selon la revendication 2, caractérisé par le fait que ledit rapport de transformation est voisin dudit rapport de compression.

5/ Générateur selon la revendication 1, caractérisé par le fait que chaque dit étage de compression (C13, L10, TR5) est muni de deux noyaux de matériau ferromagnétique, l'un (N10) étant ledit noyau saturable qui coopère avec ledit enroulement de compression (L10), l'autre (M5) étant un noyau de transformateur non saturable couplé aux dits enroulements primaire (P5) et secondaire (Q5) et présentant un volume suffisant pour éviter une saturation lorsque le courant de la dite décharge du condensateur de stockage (C13) atteint son intensité maximale.

# FIG.1

# FIG.2

# FIG.3

# FIG.4

# FIG.5

# FIG.6

# FIG.7

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | INSTRUMENTS AND EXPERIMENTAL TECHNIQUES, vol. 21, no. 5, partie 1, septembre/octobre 1978, pages 1284-1286, Plenum Publishing Corp.; A.V. BARMIN et al.: "Generator of pulses for magnetron modulation in the centimeter band" * Page 1284, ligne 17 - page 1285; figure 1 * | 1-5 | H 03 K 3/57 H 03 K 17/80 |
| A | INSTRUMENTS AND EXPERIMENTAL TECHNIQUES, vol. 19, no. 3, partie 2, mai/juin 1976, pages 769-772; A.I. DUBNEV et al.: "Obtaining pulses having a rectangular shape in magnetothyristor shapers" * Page 771, ligne 11 - page 772, ligne 4; figure 2 * | 1 | |

DOMAINES TECHNIQUES RECHERCHES (Int. Cl.4)

H 03 K
H 01 S

Le présent rapport a été établi pour toutes les revendications

| Lieu de la recherche | Date d'achèvement de la recherche | Examinateur |
|---|---|---|
| LA HAYE | 03-10-1988 | CANTARELLI R.J.H. |